Europäisches Patentamt

European Patent Office

Office européen des brevets

(11) Veröffentlichungsnummer: **0 307 674**
**A2**

(12) **EUROPÄISCHE PATENTANMELDUNG**

(21) Anmeldenummer: 88113825.9

(22) Anmeldetag: 25.08.88

(51) Int. Cl.⁴ **C30B 25/00 , C01F 7/00**

(30) Priorität: 18.09.87 DE 3731454

(43) Veröffentlichungstag der Anmeldung:
22.03.89 Patentblatt 89/12

(84) Benannte Vertragsstaaten:
AT BE CH DE FR GB IT LI NL SE

(71) Anmelder: HOECHST AKTIENGESELLSCHAFT
Postfach 80 03 20
D-6230 Frankfurt am Main 80(DE)

(72) Erfinder: Peters, Dieter, Dr.
Schaesbergstrasse 3
D-5030 Hürth(DE)

(54) Hexaamminaluminiumjodidmonoammoniakat und Verfahren zu dessen Herstellung.

㊗ Kristallines Hexaamminaluminiumjodidmonoammoniakat wird durch bestimmte Röntgenbeugungslinien (Cu, K $\alpha$ ) der 15 stärksten Linien in der Reihenfolge abnehmender Intensität charakterisiert. Einkristalle des Hexaamminaluminiumjodidmo noammoniakats kristallisieren in der Raumgruppe Pmn2₁ mit den Gitterkonstanten

$a$ = 7.600    [ Å ]
$b$ = 13.315    [ Å ]
$c$ = 15,051    [ Å ]
$\alpha = \beta = \gamma = 90°$ und besetzen bestimmte Lageparameter.

Außerdem werden Verfahren zur Herstellung von Hexaamminaluminiumjodidmonoammoniakat durch Umsetzung von Aluminium,Jodverbindung und Ammoniak bzw. Aluminiumjodid und flüssigem Ammoniak angegeben.

EP 0 307 674 A2

## Hexaamminaluminiumjodidmonoammoniakat und Verfahren zu dessen Herstellung

Die vorliegende Erfindung betrifft Hexaamminaluminiumjodidmonoammoniakat in kristallinem Zustand und als Einkristall sowie Verfahren zu dessen Herstellung.

Untersuchungen über Amminsalze von Aluminiumjodid sind von G.W. Watt und J.H. Braun in J.Am. Chem. Soc., Bd 78 (1956) Seiten 5494 - 5496 beschrieben. Es wurde gefunden, daß $AlI_3 . 20NH_3$ oberhalb von -26°C unbeständig ist. Wenn $AlI_3 . 20 NH_3$ bei Unterdruck erwärmt wird, bilden sich schließlich bei 25°C und $10^{-3}$ bar weiße Kristalle von $AlI_3 . 6NH_3$. Das $AlI_3 . 6NH_3$ kann im Vakuum zum $AlI_3 . 5NH_3$ überführt werden.

In dieser Arbeit ist weiter auf Seite 5495 referiert, daß Aluminium mit Jod und Ammoniak nur dann reagieren, wenn Quecksilber als Katalysator zugefügt ist. Überraschend wurde nun gefunden, daß Aluminium, auch in Abwesenheit eines Katalysators, durch Jodverbindungen in Ammoniak direkt zu Amminsalzen des Aluminiumjodids umgesetzt werden kann.

Die Aufgabe der vorliegenden Erfindung ist es, ein Hexaamminaluminiumjodidmonoammoniakat in kristallinem sowie einkristallinem Zustand in hoher Reinheit bereitzustellen sowie ein Verfahren zu dessen Herstellung.

Es wurde nun gefunden, daß kristallines Hexaamminaluminiumjodidmonoammoniakat durch folgende Röntgenbeugungslinien (Cu, $K_\alpha$) der 15 stärksten Linien in der Reihenfolge abnehmender Intensität charakterisiert ist:

| Linie | $I/I_0$ | 2 θ |
|-------|---------|------|
| 1 | 100 | 21,2 |
| 2 | 34 | 23,4 |
| 3 | 32 | 24,0 |
| 4 | 26 | 27,4 |
| 5 | 25 | 18,9 |
| 6 | 21 | 18,7 |
| 7 | 21 | 30,3 |
| 8 | 20 | 32,6 |
| 9 | 18 | 23,2 |
| 10 | 12 | 26,1 |
| 11 | 11 | 17,8 |
| 12 | 8 | 14,8 |
| 13 | 8 | 14,5 |
| 14 | 8 | 26,8 |
| 15 | 6 | 24,6 |

und Einkristalle des Hexaamminaluminiumjodidmonoammoniakats, in der Raumgruppe $Pmn2_1$ mit den Gitterkonstanten

a = 7.600    [ Å ]
b = 13.315   [ Å ]
c = 15,051   [ Å ]
$\alpha = \beta = \gamma = 90°$ kristallisiert sind und folgende Lageparameter besetzen (alle Lagen sind voll besetzt)

EP 0 307 674 A2

| Nr. | Element | X | Y | Z | Isotroper Temperaturfaktor [$\overset{\circ}{A}\alpha$] |
|---|---|---|---|---|---|
| 1 | I | 0.000000 | 0.314500 | 0.000000 | 3.130 |
| 2 | I | 0.000000 | 0.638100 | 0.089970 | 2.920 |
| 3 | I | 0.000000 | 0.137200 | 0.680120 | 2.770 |
| 4 | I | 0.000000 | 0.417600 | 0.372200 | 3.820 |
| 5 | I | 0.000000 | 0.922100 | 0.394200 | 4.030 |
| 6 | I | 0.000000 | 0.813800 | 0.769000 | 3.750 |
| 1 | A 1 | 0.000000 | 0.477300 | 0.731900 | 1.910 |
| 2 | A 1 | 0.000000 | 0.973900 | 0.034900 | 2.000 |
| 1 | N | 0.000000 | 0.049000 | 0.912000 | 4,500 |
| 2 | N | 0.000000 | 0.547000 | 0.847400 | 1.400 |
| 3 | N | 0.000000 | 0.901000 | 0.153000 | 4.100 |
| 4 | N | 0.000000 | 0.402000 | 0.616500 | 2.500 |
| 5 | N | 0.206000 | 0.069900 | 0.080900 | 3.000 |
| 6 | N | 0.209000 | 0.383000 | 0.779400 | 2.600 |
| 7 | N | 0.326000 | 0.120100 | 0.487300 | 2.000 |
| 8 | N | 0.326000 | 0.431900 | 0.183200 | 2.400 |
| 9 | N | 0.000000 | 0.150000 | 0.259000 | 2.900 |
| 10 | N | 0.000000 | 0.669000 | 0.531000 | 5.200 |

Gegenstand der Erfindung ist auch ein Verfahren zur Herstellung von Hexaamminaluminiumjodidmonoammoniakat durch Umsetzung von Aluminium, Jodverbindung und Ammoniak, bei dem die Reaktanten ohne Zusatz von Quecksilber zwischen Raumtemperatur und 600 °C bei Ammoniakdrucken von 8 bis 2000 bar in flüssigem Ammoniak umgesetzt werden und das überschüssige Ammoniak nach beendeter Reaktion bei einer Temperatur von 10 bis 60 °C durch Verdampfen gegen Normaldruck entfernt wird. In einer bevorzugten Ausführungsform wird die Umsetzung zwischen 70 und 200 °C, insbesondere 110 und 130 °C, unter einem Druck von 20 bis 200 bar, insbesondere 70 bis 110 bar, durchgeführt und das überschüssige Ammoniak nach beendeter Reaktion bei einer Temperatur von 15 bis 30 °C durch Verdampfen gegen Normaldruck entfernt.

Als Jodverbindung wird elementares Jod oder Ammoniumjodid in einem atomaren Verhältnis Al : I = 1 : (2 - 3,1) eingesetzt.

Eine Verfahrensvariante liegt vor, wenn bei einem atomaren Al-Überschuß gegenüber Jod das nicht umgesetzte Aluminium aus dem Fertigprodukt durch Sieben abgetrennt wird oder das nicht umgesetzte Aluminium und ungelöste Verunreinigungen aus der flüssigen Ammoniakphase durch Filtration oder Dekantation ausgeschleust werden.

Es wurde gefunden, daß die Reaktionsgeschwindigkeit gesteigert wird, wenn als Katalysator den Reaktanten Chlor oder ein anorganisches Chlorid, vorzugsweise Aluminiumchlorid oder Ammoniumchlorid, als Katalysator in einer Menge von 0,05 - 10,0, insbesondere von 0,8 - 1,2 Gewichts%, berechnet auf eingesetztes I, zudosiert wird.

Eine Variante des erfindungsgemäßen Verfahrens zur Herstellung von Hexaamminaluminiumjodidmonoammoniakat ist gegeben durch Umsetzung von Aluminiumjodid mit flüssigem Ammoniak und anschließender Entfernung des überschüssigen Ammoniaks bei einer Temperatur von 10 bis 60 °C, insbesondere 15 bis 30 °C, durch Verdampfen gegen Normaldruck.

Aus den Gitterkonstanten, die am Einkristall ermittelt wurden, konnte berechnet werden, daß die Röntgenbeugungslinie Nr. 1 bei 21,2 ° aus 2 Röntgenbeugungslinien bestehen muß; und zwar eine Linie für $I_1$ bei 21,2 ° mit der Intensität 100,0 und $I_1'$ bei 21,3 ° mit der Intensität 94,5. Bei der Angabe der Werte $I/I_0$ im Patentanspruch 1 wurde für den Wert $I_0$ die Summe aus $I_1 + I_1'$ eingesetzt, da das benutzte Röntgengerät nur $I_0 = I_1 + I_1'$ wegen ungenügender Trennleistung gemessen hat.

Die erhaltenen Produkte können in Kunstharze als Flammschutzmittel eingearbeitet werden.

Die folgenden Beispiele dienen zur Erläuterung der Erfindung, ohne daß darin eine Einschränkung zu sehen ist.

3

Beispiel 1

In einem emaillierten, heizbaren Rührautoklaven wurden unter Inertgas ($N_2$, Ar) 27 Teile Aluminiumschnitzel und 435 Teile Ammoniumjodid vorgelegt. Nach Evakuieren des Autoklaven wurden 561 Teile Ammoniak einkondensiert. Der Autoklav wurde auf 75 °C erhitzt und 99 Stunden bei dieser Temperatur belassen. Es stellte sich ein Druck von 35 bar ein. Anschließend wurde der Autoklav bei Raumtemperatur auf Normaldruck entspannt. Das Produkt hatte folgende Analyse:

$Al_{0,179}$  $I_{0,573}$  $N_{1,289}$

und entsprach damit der Formel

$[Al(NH_3)_6] I_3(NH_3) + 0.201 NH_4I$

Bezogen auf das Aluminium betrug die Ausbeute 94 %.

Beispiel 2

In dem Autoklaven wurden unter Inertgas ($N_2$, Ar) 27 Teile Aluminiumschnitzel und 435 Teile Ammoniumjodid vorgelegt. Nach Evakuieren des Autoklaven wurden 357 Teile Ammoniak einkondensiert und der verschlossene Autoklav auf 120 °C erhitzt und 17 Stunden bei dieser Temperatur belassen. Es stellte sich ein Druck von 90 bar ein.
Der Autoklav wurde bei 50 °C auf Normaldruck entspannt. Das Produkt hatte folgende Analyse:

$Al_{0,174}$  $I_{0,580}$  $N_{1,27}$

und entsprach damit der Formel

$[Al/NH_3)_6] I_3(NH_3)_{0,97} + 0,333 NH_4I$

Bezogen auf das Aluminium betrug die Ausbeute 90 %.

Beispiel 3

In den Autoklaven wurden unter Inertgas ($N_2$, Ar) 27 Teile Aluminiumschnitzel und 290 Teile Ammoniumjodid vorgelegt. Nach Evakuieren wurden 408 Teile Ammoniak einkondensiert und der verschlossene Autoklav auf 400 °C erhitzt und 65 Stunden bei 150 bar gehalten.
Der Autoklav wurde bei 25 °C auf Normaldruck entspannt und das erhaltene Produkt über ein Sieb mit einer lichten Maschenweite von 0,20 mm vom überschüssigen Aluminium abgesiebt. Der Umsatz, bezogen auf Jod, betrug 100 %.
Das Produkt hatte folgende Analyse:

$Al_{0,196}$  $I_{0,568}$  $N_{1,326}$

und entsprach damit folgender Formel

$[Al(NH_3)_6] I_3(NH_3) + 0,037 Al$

Beispiel 4

Das Beispiel 2 wurde wiederholt mit der Änderung, daß zusätzlich 4 Teile Ammoniumchlorid in den Autoklaven eingegeben wurden und die Reaktionsdauer auf 8 Stunden verkürzt wurde.
Das Produkte hatte folgende Analyse:

$Al_{0,166}$  $I_{0,576}$  $N_{1,253}$  $Cl_{0,014}$

und entsprach damit der Formel

$[Al(NH_3)_6] I_3(NH_3)_{0,99} + 0,473 NH_4I + 0,084 NH_4Cl$

Bezogen auf das Aluminium betrug die Ausbeute 86 %.

Beispiel 5

Das Beispiel 3 wurde wiederholt mit der Änderung, daß jetzt 705 Teile Ammoniak einkondensiert wurden.

Nach 65 Stunden Reaktionsdauer bei $400\,^\circ$ C wurde der Autoklav auf Raumtemperatur abgekühlt und das Reaktionsgemisch über ein Druckfilter aus dem Autoklaven entnommen. Das Ammoniak im Filtrat wurde bei Raumtemperatur unter Normaldruck verdampft. Es verblieben 524 Teile Kristalle, die folgende Analyse hatten:

$Al_{0,187}$ $I_{0,570}$ $N_{1,318}$

Die Analysenwerte entsprachen damit der Formel

$[\,Al(NH_3)_6\,]\,I_3(NH_3) + 0,048\,NH_4I$

Auf dem Druckfilter verblieben 0,44 Teile Rückstand, der zu 97 Gew.-% aus Aluminium bestand.

Beispiel 6

Käufliches $AlI_3$ der Firma Ventron, Karlsruhe, wurde zweimal über Aluminium der Firma VAW, Bonn, destilliert. Unter Wasserausschluß wurden auf 100 g Aluminiumjodid 500 ml Ammoniak bei $-40\,^\circ$ C kondensiert. Der verschlossene Autoklav wurde dann auf $20\,^\circ$ C innerhalb von 1 Stunde erwärmt und bei dieser Temperatur gegen Normaldruck entspannt.
Das Produkt hatte folgende Analyse:

$Al_{0,186}$ $I_{0,565}$ $N_{1,30}$

und entsprach damit der Formel

$[\,Al(NH_3)_6\,]\,I_3(NH_3)_{0,95} + 0,038\,NH_4I$

Beispiel 7

In den Autoklaven wurden 27 Teile Aluminiumschnitzel, 392 Teile Jod und 4 Teile Aluminiumchlorid vorgelegt. Nach Evakuieren wurden 450 Teile Ammoniak einkondensiert und der verschlossene Autoklav 24 Stunden bei $110\,^\circ$ C unter einem Druck von 85 bar gehalten.
Der Autoklav wurde dann bei $60\,^\circ$ C auf Normaldruck entspannt.
Das Produkt hatte folgende Analyse:

$Al_{0,182}$ $I_{0,562}$ $N_{1,294}$ $Cl_{0,017}$

und entsprach damit der Formel

$[\,Al(NH_3)_6\,]\,I_3(NH_3)_{0,92} + 0,083\,NH_4I + 0,093\,NH_4Cl$

Bezogen auf Aluminium betrug die Ausbeute 97 %.

**Ansprüche**

1. Kristallines Hexaamminaluminiumjodidmonoammoniakat, dadurch gekennzeichnet, daß es durch folgende Röntgenbeugungslinien (Cu, $K_\alpha$) der 15 stärksten Linien in der Reihenfolge abnehmender Intensität charakterisiert ist:

EP 0 307 674 A2

| Linie | I/I$_0$ | 2 θ |
|---|---|---|
| 1 | 100 | 21,2 |
| 2 | 34 | 23,4 |
| 3 | 32 | 24,0 |
| 4 | 26 | 27,4 |
| 5 | 25 | 18,9 |
| 6 | 21 | 18,7 |
| 7 | 21 | 30,3 |
| 8 | 20 | 32,6 |
| 9 | 18 | 23,2 |
| 10 | 12 | 26,1 |
| 11 | 11 | 17,8 |
| 12 | 8 | 14,8 |
| 13 | 8 | 14,5 |
| 14 | 8 | 26,8 |
| 15 | 6 | 24,6 |

2. Einkristalle des Hexaamminaluminiumjodidmonoammoniakats, dadurch gekennzeichnet, daß diese in der Raumgruppe Pmn2$_1$ mit den Gitterkonstanten

a = 7.600 [ Å ]
b = 13.315 [ Å ]
c = 15,051 [ Å ]
α = β = γ = 90° kristallisiert sind und folgende Lageparameter besetzen (alle Lagen sind voll besetzt):

| Nr. | Element | X | Y | Z |
|---|---|---|---|---|
| 1 | I | 0.000000 | 0.314500 | 0.000000 |
| 2 | I | 0.000000 | 0.638100 | 0.089970 |
| 3 | I | 0.000000 | 0.137200 | 0.680120 |
| 4 | I | 0.000000 | 0.417600 | 0.372200 |
| 5 | I | 0.000000 | 0.922100 | 0.394200 |
| 6 | I | 0.000000 | 0.813800 | 0.769000 |
| 1 | A 1 | 0.000000 | 0.477300 | 0.731900 |
| 2 | A 1 | 0.000000 | 0.973900 | 0.034900 |
| 1 | N | 0.000000 | 0.049000 | 0.912000 |
| 2 | N | 0.000000 | 0.547000 | 0.847400 |
| 3 | N | 0.000000 | 0.901000 | 0.153000 |
| 4 | N | 0.000000 | 0.402000 | 0.616500 |
| 5 | N | 0.206000 | 0.069900 | 0.080900 |
| 6 | N | 0.209000 | 0.383000 | 0.779400 |
| 7 | N | 0.326000 | 0.120100 | 0.487300 |
| 8 | N | 0.326000 | 0.431900 | 0.183200 |
| 9 | N | 0.000000 | 0.150000 | 0.259000 |
| 10 | N | 0.000000 | 0.669000 | 0.531000 |

3. Verfahren zur Herstellung von Hexaamminaluminiumjodidmonoammoniakat durch Umsetzung von Aluminium, Jodverbindung und Ammoniak, dadurch gekennzeichnet, daß die Reaktanten ohne Zusatz von Quecksilber zwischen Raumtemperatur und 600° C bei Ammoniakdrücken von 8 bis 2000 bar in flüssigem Ammoniak umgesetzt werden und das überschüssige Ammoniak nach beendeter Reaktion bei einer Temperatur von 10 bis 60° C durch Verdampfen gegen Normaldruck entfernt wird.

4. Verfahren nach Anspruch 3, dadurch gekennzeichnet, daß die Umsetzung zwischen 70 und 200° C, insbesondere 110 und 130° C, erfolgt.

5. Verfahren nach Anspruch 3, dadurch gekennzeichnet, daß die Umsetzung bei einem Ammoniakdruck von 20 bis 200 bar, insbesondere von 70 bis 110 bar, erfolgt.

6

6. Verfahren nach Anspruch 3, dadurch gekennzeichnet, daß das überschüssige Ammoniak nach beendeter Reaktion bei einer Temperatur von 15 bis 30 C durch Verdampfen gegen Normaldruck entfernt wird.

7. Verfahren nach einem der Ansprüche 3 bis 6, dadurch gekennzeichnet, daß als Jodverbindung elementares Jod oder Ammoniumjodid benutzt wird.

8. Verfahren nach einem der Ansprüche 3 bis 7, dadurch gekennzeichnet, daß ein atomares Verhältnis Al : I von 1 : (2 - 3,1) eingestellt wird.

9. Verfahren nach einem der Ansprüche 3 bis 8, dadurch gekennzeichnet, daß bei einem atomaren Al-Überschuß gegenüber Jod das nicht umgesetzte Aluminium aus dem Fertigprodukt durch Sieben abgetrennt wird.

10. Verfahren nach einem der Ansprüche 3 bis 8, dadurch gekennzeichnet, daß bei einem atomaren Al-Überschuß gegenüber Jod das nicht umgesetzte Aluminium und ungelöste Verunreinigungen aus der flüssigen Ammoniakphase durch Filtration oder Dekantation ausgeschleust werden.

11. Verfahren nach einem der Ansprüche 3 bis 10, dadurch gekennzeichnet, daß als Katalysator den Reaktanten Chlor oder ein anorganisches Chlorid, vorzugsweise Aluminiumchlorid oder Ammoniumchlorid, in einer Menge von 0,05 - 10,0, insbesondere von 0,8 - 1,2 Gewichts%, berechnet auf eingesetztes I, zudosiert wird.

12. Verfahren zur Herstellung von Hexaamminaluminiumjodidmonoammoniakat durch Umsetzung von Aluminiumjodid mit flüssigem Ammoniak, dadurch gekennzeichnet, daß nach der Umsetzung das überschüssige Ammoniak bei einer Temperatur von 10 bis 60 C, insbesondere 15 bis 30 C, durch Verdampfen gegen Normaldruck entfernt wird.